# EUROPÄISCHE PATENTSCHRIFT

(11) **EP 0 509 113 B1**
(45) Veröffentlichungstag und Bekanntmachung des Hinweises auf die Patenterteilung: **07.10.1998**
(21) Anmeldenummer: 91106068.9
(22) Anmeldetag: 16.04.1991
(51) Int. Cl.: H03F 3/30, H03F 1/32, H03F 3/21

(54) **Ausgangspufferverstärker mit grossem Signalhub**
Output buffer amplifier with high signal amplitude
Amplificateur de sortie tampon à signal d'amplitude élevée

(43) Veröffentlichungstag der Anmeldung: 21.10.1992
(73) Patentinhaber: SIEMENS AKTIENGESELLSCHAFT, 80333 München (DE)
(72) Erfinder: Koch, Rudolf, Dr., W-8052 Unterhaching (DE); Mistlberger, Fritz, W-8052 Moosburg (DE)

(56) Entgegenhaltungen:
- EP-A- 0 406 964
- US-A- 4 464 634
- US-A- 4 739 281
- IEEE JOURNAL OF SOLID-STATE CIRCUITS. Bd. SC-24, Nr. 1, Februar 1989, NEW YORK US Seiten 181 - 183; K. NAGARAJ: 'Large-Swing CMOS Buffer Amplifier'

## Beschreibung

Die Erfindung betrifft einen Ausgangspufferverstärker.

Ausgangspufferverstärker werden bei der analogen Signalverarbeitung für eine Vielzahl von Anwendungen benötigt, wie beispielsweise zum Betreiben von Hörkapseln und Lautsprechern bei Telefonendgeräten. Die Anforderungen, die dabei an einen Ausgangspufferverstärker gestellt werden, sind u.a. die Fähigkeit niederohmige Lasten mit teilweise hohem kapazitiven Anteil zu treiben, ein großer Ausgangssignalhub bis knapp an die Betriebsspannung, eine ausreichende Linearität ohne Ubernahmeverzerrungen und eine geringe Ruhestromaufnahme. Gebräuchliche Ausgangspufferverstärker sind als Endstufen der Klasse AB in CMOS-Technik ausgeführt und weisen zwei draingekoppelte komplementäre MOS-Transistoren auf. Die beiden MOS-Transistoren werden von Fehlerverstärkern angesteuert, die jeweils von den gekoppelten Drain-Anschlüssen der beiden MOS-Transistoren auf einen Eingang des Fehlerverstärkers gegengekoppelt sind. Derartige Ausgangspufferverstärker sind beispielsweise aus K.E. Brehmer und J.B. Wieser, "Large swing CMOS power amplifier", IEEE J. Solid-State Circuits, Vol. SC-18, S. 624-629, Dezember 1983; B.K. Ahuja, P.R. Gray, W.M. Baxter und G.T. Uehara, "A programmable CMOS dual channel interface processor for telecommunications applications", IEEE J. Solid-State Circuits, Vol. SC-19, S. 892-899, Dezember 1984 sowie J.A. Fisher, "A high-performance CMOS power amplifier", IEEE J. Solid State Circuits, Vol. SC-20, S. 1200-1205, Dezember 1985 bekannt.

Aus dem Stand der Technik EP 0406964 A1 ist eine Verstärkeranordnung bekannt. Hierbei wird ein Eingangssignal einem ersten und einem zweiten Verstärker über eine zwischengeschaltete Einheit zugeführt. Beide Verstärker sind ausgangsseitig miteinander verbunden. Die zwischengeschaltete Einheit erzeugt zwei komplementäre Signale, die in Bezug zum von den Verstärkern gelieferten Ausgangssignal stehen. Die Maximalwerte korrespondieren zu den individuellen Ausgangssignalen der beiden Verstärker. Das Ausgangssignal bestimmt, welcher der beiden Verstärker voll ausgesteuert wird.

Der Vorteil von draingekoppelten Endstufen ist, daß der Ausgangssignalhub größer ist als bei einfachen sourcegekoppelten Endstufen, wo große Gate-Source-Spannungen der Ausgangstransistoren den Signalhub stark einschränken. Ein Problem bei draingekoppelten Endstufen ist im allgemeinen das Auftreten unterschiedlicher Offsetspannungen in den beiden Fehlerverstärkern, welche zu großen Abweichungen beim Ruhestrom führen. Daher ist bei der praktischen Anwendung dieses Schaltungskonzepts ein zusätzlicher Aufwand zur Kontrolle des Ruhestroms erforderlich.

Bei J.A. Fisher, "A high-performance CMOS power amplifier", IEEE J. Solid State Circuits, Vol. SC-20, S. 1200-1205, Dezember 1985 ist ein Ausgangspufferverstärker gezeigt, der zwei Endstufen, nämlich eine sourcegekoppelte Endstufe und eine sourcegekoppelte Endstufe miteinander kombiniert. Größere Ausgangsleistungen werden dabei hauptsächlich durch die draingekoppelte Endstufe. Bei kleinen Ausgangsleistungen, also beispielsweise im Bereich des Ruhestroms der draingekoppelten Endstufe, ist diese aufgrund vorgeschalteter Offsetspannungsquellen außer Betrieb. Die Ausgangsleistung wird nun ausschließlich von der sourcegekoppelten Endstufe erbracht. Für diesen Betriebsfall kann der Ruhestrom exakt durch eine entsprechende Dimensionierung der MOS-Transistoren eingestellt werden. Die sourcegekoppelte Endstufe reduziert zudem durch die Fehlerverstärker hervorgerufene Phasenverschiebungen, indem sie die draingekoppelte Endstufe für hohe Frequenzen überbrückt.

Ein Problem bei dieser Schaltung stellen allerdings zwei Dioden in einer zur Ansteuerung der Endstufen vorgesehenen Eingangsstufe dar, die zur Vorspannungserzeugung der üblichen Sourcefolgerstufe benötigt werden. Die an den beiden Dioden abfallenden Spannungen schränken den Ausgangsspannungshub des gesamten Ausgangspufferverstärkers stark ein. Insbesondere bei einer Realisierung in CMOS-Technologie bewirkt der Spannungsabfall an beiden Dioden eine Einschränkung des Ausgangsspannungshubs von mindestens 2 V. Für Ausgangspufferverstärker mit einer Versorgungsspannung von 5 V stellt dies eine erhebliche Einschränkung des Arbeitsbereiches dar.

Bei K. Nagaraj, "Large-Swing CMOS Buffer Amplifier", IEEE Journal of Solid-State Circuits, Vol. 24, No. 1, Februar 1989, wird eine Möglichkeit zur Verbesserung des Ausgangsspannungshubs bei vorstehend dargelegter Schaltung aufgezeigt. Dazu sind zusätzlich zwei komplementäre MOS-Transistoren vorgesehen, die ein Anheben bzw. Absenken des Potentials am Abgriff der beiden in Reihe geschalteten Dioden bis nahe an beide Versorgungspotentiale ermöglichen. Folglich vergrößert sich auch der Ausgangssignalhub des Ausgangspufferverstärkers entsprechend.

Nachteil bei der zuletzt genannten Schaltung ist jedoch, daß aufgrund der zusätzlichen komplementären MOS-Transistoren in bestimmten Aussteuerungsbereichen die neben den beiden Dioden in der Eingangsstufe eingesetzten MOS-Transistoren im Triodenbereich betrieben werden, was insgesamt zu einer Zunahme der Verzerrungen beim Ausgangspufferverstärker führt.

Aufgabe der Erfindung ist es daher, einen Ausgangspufferverstärker der vorstehend genannten Art anzugeben, der diesen Nachteil nicht aufweist.

Die Aufgabe wird durch einen Ausgangspufferverstärker gemäß Patentanspruch 1 oder 2 gelöst. Ausgestaltungen und Weiterbildungen des Erfindungsgedankens sind Gegenstand von Unteransprüchen.

Die Erfindung wird nachfolgend anhand der in den Figuren der Zeichnung dargestellten Ausführungsbeispiele näher erläutert, wobei gleiche Elemente mit gleichen Bezugszeichen versehen sind. Es zeigt:
- Figur 1: ein erstes Ausführungsbeispiel eines erfindungsgemäßen Ausgangspufferverstärkers und
- Figur 2: ein zweites Ausführungsbeispiel eines erfindungsgemäßen Ausgangspufferverstärkers.

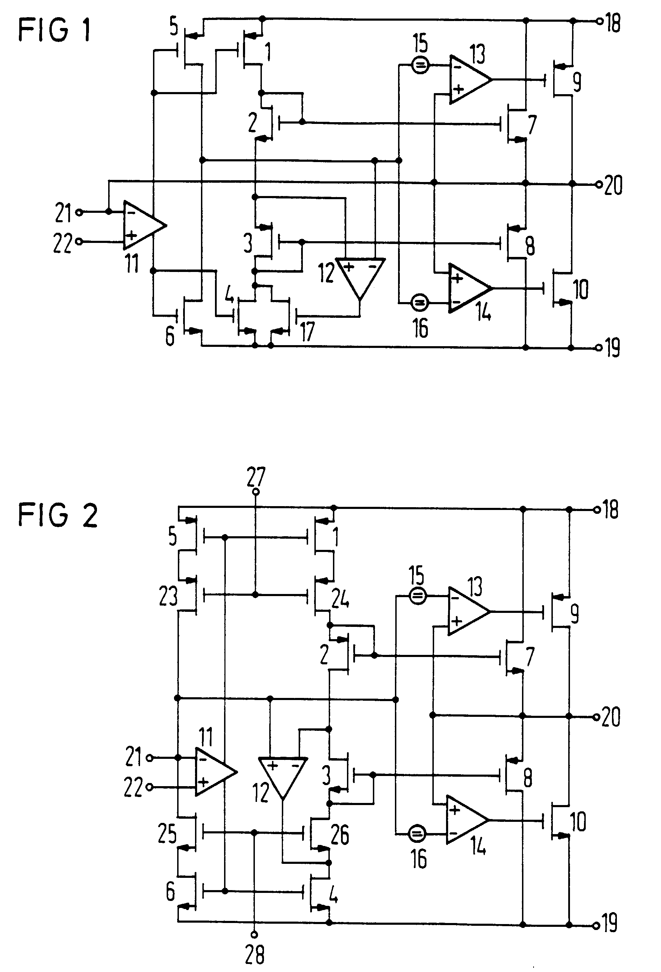

Das Ausführungsbeispiel nach Figur 1 zeigt einen Ausgangspufferverstärker mit einer Endstufe für kleine Ausgangsleistungen und einer Endstufe für große Ausgangsleistungen, deren Ausgänge einen gemeinsamen Ausgang 20 bildend miteinander verbunden sind, die durch das gleiche Eingangssignal angesteuert werden und die jeweils dem Eingangssignal entsprechende, interne Signale führen und mit einer Regelstufe, der die internen Signale beider Endstufen zugeführt werden und die davon abhängig ein internes Signal der Endstufe für kleine Ausgangsleistungen regelt. Die Endstufe für große Ausgangsleistungen besteht aus einem MOS-Transistor 9 vom p-Kanal-Typ, dessen Sourceanschluß mit einem positiven Versorgungspotential 18 und dessen Drainanschluß mit dem Ausgang 20 verbunden ist, und aus einem MOS-Transistor 10 vom n-Kanal-Typ, dessen Sourceanschluß mit einem negativen Versorgungspotential 19 und dessen Drainanschluß mit dem Ausgang 20 verbunden ist. Die Gateanschlüsse dieser beiden komplementären MOS-Ausgangstransistoren der MOS-Transistoren 9 und 10 sind an den Ausgang jeweils eines Fehlerverstärkers 13 bzw. 14 angeschlossen, deren nichtinvertierende Eingänge miteinander und mit dem Ausgang 20 verschaltet sind. Die invertierenden Eingänge der beiden Fehlerverstärker 13 und 14 sind unter Vorschalten jeweils einer Offset-Spannungsquelle 15 bzw. 16 miteinander sowie mit dem invertierenden Eingang der als Differenzverstärker 12 ausgeführten Regelstufe verbunden.

Die Endstufe für kleine Ausgangsleistungen besteht aus zwei komplementären MOS-Eingangstransistoren, nämlich einem MOS-Transistor 1 vom p-Kanal-Typ, dessen Sourceanschluß mit dem positiven Versorgungspotential 18 beaufschlagt ist, und aus einem MOS-Transistor 4 vom n-Kanal-Typ, dessen Sourceanschluß mit dem negativen Versorgungspotential 19 beaufschlagt ist. Der Drain-Source-Strecke des MOS-Transistors 4 ist die Drain-Source-Strecke eines MOS-Transistors 17 vom n-Kanal-Typ parallelgeschaltet, dessen Gateanschluß mit dem Ausgang des Differenzverstärkers 12 verbunden ist. Die Drainanschlüsse der beiden MOS-Transistoren 1 und 4 sind über eine Reihenschaltung von zwei Dioden in Durchlaßrichtung miteinander verbunden. Die beiden Dioden sind im gezeigten Ausführungsbeispiel durch einen MOS- Transistor 2 vom n-Kanal-Typ, bei dem Gate- und Drain-Anschluß miteinander sowie mit dem Drain-Anschluß des MOS-Transistors 1 verbunden sind, und durch einen MOS-Transistor 3 vom p-Kanal- Typ, bei dem Gate- und Drain-Anschluß miteinander sowie mit dem Drain-Anschluß des MOS-Transistors 4 verbunden sind, gegeben. Die Source-Anschlüsse der beiden MOS-Transistoren 2 und 3 sind miteinander gekoppelt und an den nichtinvertierenden Eingang der Regelstufe, also dem nichtinvertierenden Eingang des Differenzverstärkers 12, angeschlossen. An den Drain-Anschlüssen der MOS-Transistoren 1 und 4, sind zwei weitere komplementäre MOS-Ausgangstransistoren angeschlossen. Dies sind zum einen ein MOS-Transistor 7 vom n-Kanal-Typ, dessen Gate-Anschluß mit dem Drain-Anschluß des MOS-Transistors 1 und dessen Drain-Anschluß mit dem positiven Versorgungspotential 18 verbunden ist, und aus einem MOS-Transistor 8 vom p-Kanal-Typ, dessen Gate-Anschluß mit dem Drain-Anschluß des MOS-Transistors 4 und dessen Drain-Anschluß mit dem negativen Versorgungspotential 19 verbunden ist. Die Source-Anschlüsse der beiden MOS-Transistoren 7 und 8 sind miteinander gekoppelt und bilden den Ausgang der Endstufe für kleine Ausgangsleistungen. Sie sind daher zudem an den Ausgang 20 angeschlossen.

In Weiterbildung der Erfindung ist ein MOS-Transistor 5 vom p-Kanal-Typ über seinen Drain-Anschluß mit dem invertierenden Eingang des Differenzverstärkers 12 und über seinen Source-Anschluß mit dem positiven Versorgungspotential 18 verbunden. Außerdem ist ein MOS-Transistor 6 vom n-Kanal-Typ über seinen Source-Anschluß mit dem negativen Versorgungspotential 19 und über seinen Drain-Anschluß mit dem invertierenden Eingang des Differenzverstärkers 12 verschaltet. Der Gate-Anschluß des MOS-Transistors 5 ist mit dem Gate-Anschluß des MOS-Transistors 1 und der Gate-Anschluß des MOS-Transistors 6 mit dem Gate-Anschluß des MOS-Transistors 4, Eingänge des Ausgangspufferverstärkers bildend, gekoppelt. Diese beiden MOS-Eingangstransistoren, die MOS-Transistoren 5 und 6 erhöhen die Aussteuerbarkeit der Endstufe für große Ausgangsleistungen. Schließlich ist ein Eingangsverstärker 11 dem Ausgangspufferverstärker vorgeschaltet, der zwei Differenzeingänge 21 und 22 und zwei Differenzausgänge, die mit den Gateanschlüssen der MOS-Transistoren 1, 5 bzw. 4, 6 verbunden sind. Dieser ist zum einen zur Verstärkungserhöhung und zum anderen zur Impedanzanpassung vorgeseben.

Gegenüber Figur 1 ist das Ausführungsbeispiel nach Figur 2 dahingehend abgeändert, daß die MOS-Eingangstransistoren der beiden Endstufen - die MOS-Transistoren 1, 4, 5, 6 - nun jeweils Bestandteil einer Kaskadeschaltung sind. Dazu sind zwei MOS-Transistoren 23 und 24 vom p-Kanal-Typ, an deren miteinander gekoppelten Gate-Anschlüssen ein Biaspotential 27 angelegt ist, und zwei MOS-Transistoren 25 und 26 vom n-Kanal-Typ, an deren miteinander gekoppelten Gate-Anschlüssen ein Biaspotential 28 angelegt ist, vorgesehen, die über ihre Source-Drain-Strecke jeweils einem der MOS-Eingangstransistoren vom gleichen Leitungstyp drainseitig nachgeschaltet sind. Das bedeutet, daß die Source-Anschlüsse der draingekoppelten MOS-Transistoren 23 und 25 mit dem Drain-Anschluß des MOS-Transistors 24 bzw. 26 verbunden sind. Die Source-Drain-Strecken der MOS-Transistoren 24 und 26 sind dabei zwischen den Drain-Anschluß des MOS-Transistors 1 bzw. 4 und den Sourceanschluß des MOS-Transistors 2 bzw. 3 geschaltet.

Außerdem entfällt bei dem Ausführungsbeispiel nach Figur 2 der MOS-Transistor 17 aus Figur 1. Demzufolge ist der Ausgang des Differenzverstärkers 12 direkt an den Drain-Anschluß des MOS-Transistors 4 gelegt. Um die durch den MOS-Transistor 17 hervorgerufene Phasenumkehrung auszugleichen, sind bei den Ausgangspufferverstärker nach Figur 2 der invertierende und nichtinvertierende Eingang des Differenzverstärkers 12 gegenüber Figur 1 vertauscht. Schließlich unterscheiden sich die hier als beiden Spannungsfolger betriebenen und deshalb gegengekoppelten bei Ausgangspufferverstärker in der Ausführung der Gegenkopplung. Gemäß Figur 1 kann die Gegenkopplung vom Ausgang 20 auf einen Eingang des Eingangsverstärkers 11 - in beiden gezeigten Fällen sei dies der invertierende Eingang - oder gemäß Figur 2 von den miteinandergekoppelten invertierenden Eingängen der Fehlerverstärker 13 nd 14 auf einen Eingang des Eingangsverstärkers 11 erfolgen. Im ersten Fall wird eine größere Linearität und im zweiten Fall eine größere Schnelligkeit und damit eine höhere Grenzfrequenz erzielt.

Die Funktionsweise eines erfindungsgemäßen Ausgangspufferverstärkers beruht darauf, daß zwei unterschiedliche Endstufen ausgangsseitig parallelgeschaltet sind. Dabei ist eine Endstufe für einen kleinen Ausgangsleistungsbereich vorgesehen, während die andere Endstufe erst bei größeren Ausgangsleistungen aktiv wird. Um aber durch einen mangelnden Gleichlauf beider Endstufen hervorgerufene nachteilige Verhaltensweisen dieser Anordnung auszuschalten, wird erfindungsgemäß ein Regelverstärker zwischen den Eingang der Endstufe für kleine Ausgangsleistungen und dem Eingang der Endstufe für große Ausgangsleistungen geschaltet, wobei zum Einstellen des Gleichlaufs beider Endstufen ein zum Eingangssignal der Endstufe für große Ausgangsleistungen proportionales Signal und ein zum Ausgangssignal der Endstufe für kleine Leistungen proportionales Signal von Regelverstärker ausgewertet wird. Die beiden Offset-Spannungsquellen 15 und 16 bewirken daß die Endstufe für größere Ausgangsleistungen erst ab größeren Eingangssignalwerten aktiv wird. Um die Aussteuerbarkeit des gesamten Ausgangspufferverstärkers zu erhöhen, sind zusätzlich die beiden MOS-Transistoren 5 und 6 vorgesehen, die am Eingang der Endstufe für große Ausgangsleistungen einen Signalhub in Höhe der Versorgungsspannung, d.h. der Differenz von positivem und negativem Versorgungspotential 18 und 19, ermöglichen.

## Patentansprüche

1. Ausgangspufferverstärker
- bei dem eine Endstufe (9, 10, 13, 14, 15, 16) für große Ausgangsleistungen vorgesehen ist,
bei dem eine Endstufe (1, 2, 3, 4, 7, 8) für kleine Ausgangsleistungen vorgesehen ist,
- bei dem die Ausgänge der Endstufen (9, 10, 13, 14, 15, 16; 1, 2, 3, 4, 7, 8) einen gemeinsamen Ausgang (20) bildend miteinander verbunden sind,
- bei dem eine Regelstufe (12) vorgesehen ist, wobei ein Eingang der Regelstufe (12) durch ein Signal angesteuert wird, das proportional zu einem Eingangssignal der Endstufe (9, 10, 13, 14, 15, 16) für große Ausgangsleistungen ist und ein anderer Eingang der Regelstufe (12) durch ein Signal angesteuert wird, das proportional zum Ausgangssignal der Endstufe (1, 2, 3, 4, 7, 8) für kleine Ausgangsleistungen ist,
- bei dem ein MOS-Ansteuertransistor (17) vorgesehen ist und die Endstufe (1, 2, 3, 4, 7, 8) für kleine Ausgangsleistungen MOS-Eingangstransistoren (1,4) aufweist,
- bei dem der Ausgang der Regelstufe (12) über den MOS-Ansteuertransistor (17) mit der Endstufe (1, 2, 3, 4, 7, 8) für kleine Ausgangsleistungen verbunden ist, wobei der MOS-Ansteuertransistor (17) mit einem der MOS-Eingangstransistoren (4) parallelgeschaltet ist,
- bei dem die Gateanschlüsse der MOS-Eingangstransistoren (1, 4) der Endstufe (1, 2, 3, 4, 7, 8) für kleine Ausgangsleistungen mit den Gateanschlüssen der MOS-Eingangstransistoren (5, 6) vom jeweils gleichen Leitungstyp der Endstufe (9, 10, 13, 14, 15, 16) für große Ausgangsleistungen verbunden sind.

2. Ausgangspufferverstärker
- bei dem eine Endstufe (9, 10, 13, 14, 15, 16) für große Ausgangsleistungen vorgesehen ist,
bei dem eine Endstufe (1, 2, 3, 4, 7, 8) für kleine Ausgangsleistungen vorgesehen ist,
- bei dem die Ausgänge der Endstufen (9, 10, 13, 14, 15, 16; 1, 2, 3, 4, 7, 8) einen gemeinsamen Ausgang (20) bildend miteinander verbunden sind,
- bei dem eine Regelstufe (12) vorgesehen ist, wobei ein Eingang der Regelstufe (12) durch ein Signal angesteuert wird, das proportional zu einem Eingangssignal der Endstufe (9, 10, 13, 14, 15, 16) für große Ausgangsleistungen ist und ein anderer Eingang der Regelstufe (12) durch ein Signal angesteuert wird, das proportional zum Ausgangssignal der Endstufe (1, 2, 3, 4, 7, 8) für kleine Ausgangsleistungen ist,
- bei dem die Endstufe (1, 2, 3, 4, 7, 8) für kleine Ausgangsleistungen MOS-Eingangstransistoren (1,4) aufweist,
- bei dem der Ausgang der Regelstufe (12) über den Drainanschluß eines der MOS-Eingangstransistoren (4) mit der Endstufe (1, 2, 3, 4, 7, 8) für kleine Ausgangsleistungen verbunden ist,
- bei dem die Gateanschlüsse der MOS-Eingangstransistoren (1, 4) der Endstufe (1, 2, 3, 4, 7, 8) für kleine Ausgangsleistungen mit den Gateanschlüssen der MOS-Eingangstransistoren (5, 6) vom jeweils gleichen Leitungstyp der Endstufe (9, 10, 13, 14, 15, 16) für große Ausgangsleistungen verbunden sind.

3. Ausgangspufferverstärker nach Anspruch 1 oder 2,
**dadurch gekennzeichnet,**
daß die Regelstufe einen Differenzverstärker (12) aufweist.

4. Ausgangspufferverstärker nach Anspruch 1 oder 3
**dadurch gekennzeichnet,**
daß die Endstufe (1, 2, 3, 4, 7, 8) für große Ausgangsleistungen zwei draingekoppelte komplementäre MOS-Ausgangstransistoren (9, 10) und zwei jeweils den Gate-Anschlüssen der komplementären MOS-Ausgangstransistoren (9, 10) vorgeschaltete, gegengekoppelte Fehlerverstärker (13, 14), deren Eingänge unter Vorschalten jeweils einer Offsetspannungsquelle (15, 16) miteinander gekoppelt sind, aufweist.

5. Ausgangspufferverstärker nach einem der Ansprüche 1 bis 4
**dadurchch gekennzeichnet,**
daß die Endstufe (9, 10, 13, 14, 15, 16) für große Ausgangsleistungen zwei draingekoppelte MOS-Eingangstransistoren (5, 6), an deren Gate-Anschlüsse das Eingangssignal angelegt ist, aufweist.

6. Ausgangspufferverstärker nach Anspruch 4 oder 5,
**dadurch gekennzeichnet,**
daß die Gegenkopplung der Fehlerverstärker (13, 14) von den gekoppelten Drain-Anschlüssen der komplementären MOS-Ausgangstransistoren (9, 10) auf Eingänge der Fehlerverstärker (13,14) erfolgt.

7. Ausgangspufferverstärker nach einem der Ansprüche 1 bis 6,
**dadurch gekennzeichnet,**
daß die Endstufe (1, 2, 3, 4, 7, 8) für kleine Ausgangsleistungen zwei sourcegekoppelte weitere komplementäre MOS-Ausgangstransistoren (7, 8) aufweist.

8. Ausgangspufferverstärker nach einem der Ansprüche 1 bis 7,
**dadurch gekennzeichnet,**
daß die Endstufe (1, 2, 3, 4, 7, 8) für kleine Ausgangsleistungen zwei über eine Reihenschaltung aus Dioden (2, 3) in Durchlaßrichtung draingekoppelte weitere komplementäre MOS-Eingangstransistoren (7, 8), an deren Gate-Anschlüsse das Eingangssignal angelegt ist, aufweist und daß an einem Abgriff der Reihenschaltung der Dioden (2, 3) ein zum Ausgangssignal der Endstufe (1, 2, 3, 4, 7, 8) für kleine Ausgangsleistungen proportionales Signal abgenommen wird.

9. Ausgangspufferverstärker nach einem der Ansprüche 1 bis 8,
**dadurch gekennzeichnet,**
daß den komplementären MOS-Eingangstransistoren (1, 4; 5, 6) über den Gate-Anschluß an Bias-Potentialen (27, 28) liegende zusätzliche MOS-Transistoren (23, 24, 25, 26) vom jeweils gleichen Leitungstyp, Kaskodestufen bildend, drainseitig nachgeschaltet sind.

10. Ausgangspufferverstärker nach einem der Ansprüche 1 oder 3,
**dadurch gekennzeichnet,**
daß der Gate-Anschluß des MOS-Ansteuertransistors (17), mit dem Ausgang des Regelverstärkers (12) verbunden ist und dessen Drain-Source-Strecke der Drain-Source-Strecke eines der MOS-Eingangstransistoren (4) der Endstufe (1, 2, 3, 4, 7, 8) für kleine Ausgangsleistungen parallelgeschaltet ist.

## Claims

1. Output buffer amplifier
- in which an output stage (9, 10, 13, 14, 15, 16) for large output powers is provided,
- in which an output stage (1, 2, 3, 4, 7, 8) for small output powers is provided,
- in which the outputs of the output stages (9, 10, 13, 14, 15, 16; 1, 2, 3, 4, 7, 8) are connected to one another to form a common output (20),
- in which a control stage (12) is provided, one input of the control stage (12) being driven by a signal which is proportional to an input signal of the output stage (9, 10, 13, 14, 15, 16) for large output powers, and another input of the control stage (12) being driven by a signal which is proportional to the output signal of the output stage (1, 2, 3, 4, 7, 8) for small output powers,
- in which a MOS driving transistor (17) is provided and the output stage (1, 2, 3, 4, 7, 8) for small output powers has MOS input transistors (1, 4),
- in which the output of the control stage (12) is connected via the MOS driving transistor (17) to the output stage (1, 2, 3, 4, 7, 8) for small output powers, the MOS driving transistor (17) being connected in parallel with one of the MOS input transistors (4),
- in which the gate terminals of the MOS input transistors (1, 4) of the output stage (1, 2, 3, 4, 7, 8) for small output powers are connected to the gate terminals of the MOS input transistors (5, 6) of the respectively identical conduction type of the output stage (9, 10, 13, 14, 15, 16) for large output powers.

2. Output buffer amplifier
- in which an output stage (9, 10, 13, 14, 15, 16) for large output powers is provided,
- in which an output stage (1, 2, 3, 4, 7, 8) for small output powers is provided,
- in which the outputs of the output stages (9, 10, 13, 14, 15, 16; 1, 2, 3, 4, 7, 8) are connected to one another to form a common output (20),
- in which a control stage (12) is provided, one input of the control stage (12) being driven by a signal which is proportional to an input signal of the output stage (9, 10, 13, 14, 15, 16) for large output powers, and another input of the control stage (12) being driven by a signal which is proportional to the output signal of the output stage (1, 2, 3, 4, 7, 8) for small output powers,
- in which the output stage (1, 2, 3, 4, 7, 8) for small output powers has MOS input transistors (1, 4),
- in which the output of the control stage (12) is connected via the drain terminal of one of the MOS input transistors (4) to the output stage (1, 2, 3, 4, 7, 8) for small output powers,
- in which the gate terminals of the MOS input transistors (1, 4) of the output stage (1, 2, 3, 4, 7, 8) for small output powers are connected to the gate terminals of the MOS input transistors (5, 6) of the respectively identical conduction type of the output stage (9, 10, 13, 14, 15, 16) for large output powers.

3. Output buffer amplifier according to Claim 1 or 2, characterized in that the control stage has a differential amplifier (12).

4. Output buffer amplifier according to Claim 1 or 3, characterized in that the output stage (1, 2, 3, 4, 7, 8) for large output powers has two drain-coupled, complementary MOS output transistors (9, 10) and two negative-feedback error amplifiers (13, 14), which are respectively connected upstream of the gate terminals of the complementary MOS output transistors (9, 10) and whose inputs are coupled to one another with each input having a respective offset voltage source (15, 16) connected upstream of it.

5. Output buffer amplifier according to one of Claims 1 to 4, characterized in that the output stage (9, 10, 13, 14, 15, 16) for large output powers has two drain-coupled MOS input transistors (5, 6), to whose gate terminals the input signal is applied.

6. Output buffer amplifier according to Claim 4 or 5, characterized in that the negative feedback of the error amplifiers (13, 14) takes place from the coupled drain terminals of the complementary MOS output transistors (9, 10) to inputs of the error amplifiers (13, 14).

7. Output buffer amplifier according to one of Claims 1 to 6, characterized in that the output stage (1, 2, 3, 4, 7, 8) for small output powers has two source-coupled, further complementary MOS output transistors (7, 8).

8. Output buffer amplifier according to one of Claims 1 to 7, characterized in that the output stage (1, 2, 3, 4, 7, 8) for small output powers has two further complementary MOS input transistors (7, 8), which are drain-coupled via a series circuit formed by diodes (2, 3) in the forward direction and to whose gate terminals the input signal is applied, and in that a signal which is proportional to the output signal of the output stage (1, 2, 3, 4, 7, 8) for small output powers is picked off at a tap of the series circuit of the diodes (2, 3).

9. Output buffer amplifier according to one of Claims 1 to 8, characterized in that the complementary MOS input transistors (1, 4; 5, 6) have connected downstream of them on the drain side additional MOS transistors (23, 24, 25, 26) of the respectively identical conduction type, forming cascode stages, which additional MOS transistors are connected to bias potentials (27, 28) via the gate terminal.

10. Output buffer amplifier according to either of Claims 1 and 3, characterized in that the gate terminal of the MOS driving transistor (17) is connected to the output of the control amplifier (12) and its drain-source path is connected in parallel with the drain-source path of one of the MOS input transistors (4) of the output stage (1, 2, 3, 4, 7, 8) for small output powers.

## Revendications

1. Amplificateur séparateur de sortie
- dans lequel il est prévu un étage (9, 10, 13, 14, 15, 16) d'extrémité pour de grandes puissances de sortie,
- dans lequel il est prévu un étage (1, 2, 3, 4, 7, 8) d'extrémité pour de petites puissances de sortie,
- dans lequel les sorties des étages (9, 10, 13, 14, 15, 16 ; 1, 2, 3, 4, 7, 8) d'extrémité sont reliées entre elles en formant une sortie (20) commune,
- dans lequel il est prévu un étage (12) de régulation, une entrée de l'étage (12) de régulation étant commandée par un signal qui est proportionnel à un signal d'entrée de l'étage (9, 10, 13, 14, 15, 16) d'extrémité pour de grandes puissances de sortie et une autre entrée de l'étage (12) de régulation étant commandée par un signal qui est proportionnel au signal de sortie de l'étage (1, 2, 3, 4, 7, 8) de sortie pour de petites puissances de sortie,
- dans lequel un transistor (17) de commande MOS est prévu et dans lequel l'étage (1, 2, 3, 4, 7, 8) d'extrémité pour de petites puissances de sortie comporte des transistors (1, 4) d'entrée MOS,
- dans lequel la sortie de l'étage (12) de régulation est reliée à l'étage (1, 2, 3, 4, 7, 8) d'extrémité pour de petites puissances de sortie par l'intermédiaire du transistor (17) de commande MOS, le transistor (17) de commande MOS étant branché en parallèle avec l'un des transistors (4) d'entrée MOS,
- dans lequel les bornes de grille des transistors (1, 4) d'entrée MOS de l'étage (1, 2, 3, 4, 7, 8) d'extrémité pour de petites puissances de sortie sont reliées aux bornes de grille des transistors (5, 6) d'entrée MOS du même type de conductivité de l'étage (9, 10, 13, 14, 15, 16) d'extrémité pour de grandes puissances de sortie.

2. Amplificateur séparateur de sortie
- dans lequel il est prévu un étage (9, 10, 13, 14, 15, 16) d'extrémité pour ce grandes puissances de sortie,
- dans lequel il est prévu un étage (1, 2, 3, 4, 7, 8) d'extrémité pour de petites puissances de sortie,
- dans lequel les sorties des étages (9, 10, 13, 14, 15, 16 ; 1, 2, 3, 4, 7, 8) d'extrémité sont reliées entre elles en formant une sortie (20) commune,
- dans lequel il est prévu un étage (12) de régulation, une entrée de l'étage (12) de régulation étant commandée par un signal qui est proportionnel à un signal d'entrée de l'étage (9, 10, 13, 14, 15, 16) d'extrémité pour de grandes puissances de sortie et une autre entrée de l'étage (12) de régulation étant commandée par un signal qui est proportionnel au signal de sortie de l'étage (1, 2, 3, 4, 7, 8) d'extrémité pour de petites puissances de sortie,
- dans lequel l'étage (1, 2, 3, 4, 7, 8) d'extrémité pour de petites puissances de sortie comporte des transistors (1, 4) d'entrée MOS,
- dans lequel la sortie de l'étage (12) de régulation est reliée à l'étage (1, 2, 3, 4, 7, 8) d'extrémité pour de petites puissances de sortie par l'intermédiaire de la borne de drain de l'un des transistors (4) d'entrée MOS,
- dans lequel les bornes de grille des transistors (1, 4) d'entrée MOS de l'étage (1, 2, 3, 4, 7, 8) d'extrémité pour de petites puissances de sortie sont reliées aux bornes de grille des transistors (5, 6) d'entrée MOS du même type de conductivité de l'étage (9, 10, 13, 14, 15, 16) d'extrémité pour de grandes puissances de sortie.

3. Amplificateur séparateur de sortie suivant la revendication 1 ou 2, caractérisé en ce que l'étage de régulation comporte un amplificateur (12) différentiel.

4. Amplificateur séparateur de sortie suivant la revendication 1 ou 3, caractérisé en ce que l'étage (1, 2, 3, 4, 7, 8) d'extrémité pour de grandes puissances de sortie comporte deux transistors (9, 10) de sortie MOS complémentaires couplés par drain et deux amplificateurs (13, 14) d'erreurs qui sont montés en amont des bornes de grille des transistors (9, 10) de sortie MOS complémentaires, qui sont couplés en contre-réaction et dont les entrées sont couplées entre elles avec une source (15, 16) de tension de décalage en amont de chacune d'elles.

5. Amplificateur séparateur de sortie suivant l'une des revendications 1 à 4, caractérisé en ce que l'étage (9, 10, 13, 14, 15, 16) d'extrémité pour de grandes puissances de sortie comporte deux transistors (5, 6) d'entrée MOS qui sont couplés par drain et aux bcrnes de grille desquelles est appliqué un signal d'entrée.

6. Amplificateur séparateur de sortie suivant la revendication 4 cu 5, caractérisé en ce que le couplage en contre-réaction des amplificateurs (13, 14) d'erreur s'effectue des bornes de drain couplées des transistors (9, 10) de sortie MOS complémentaires sur des entrées des amplificateurs (13, 14) d'erreur.

7. Amplificateur séparateur de sortie suivant l'une des revendications 1 à 6, caractérisé en ce que l'étage (1, 2, 3, 4, 7, 8) d'extrémité pour de petites puissances de sortie comporte deux transistors (7, 8) de sortie MOS complémentaires supplémentaires couplés par source.

8. Amplificateur séparateur de sortie suivant l'une des revendications 1 à 7, caractérisé en ce que l'étage (1, 2, 3, 4, 7, 8) d'extrémité pour de petites puissances de sortie comporte deux transistors (7, 8) d'entrée MOS supplémentaires complémentaires qui sont couplés par drain dans le sens passant et aux bornes de grille desquelles le signal d'entrée est appliqué et en ce qu'un signal proportionnel au signal de sortie de l'étage (1, 2, 3, 4, 7, 8) d'extrémité pour de petites puissances de sortie est prélevé à une prise du circuit série des diodes (2, 3).

9. Amplificateur séparateur de sortie suivant l'une des revendications 1 à 8, caractérisé en ce qu'il est monté en aval des transistors (1, 4 ; 5, 6) d'entrée MOS complémentaires, côté drain, en formant des étages en cascade, des transistors (23, 24, 25, 26) MOS supplémentaires du même type de conductivité associés se trouvant à des potentiels (27, 28) de polarisation par l'intermédiaire de la borne de grille.

10. Amplificateur séparateur de sortie suivant l'une des revendications 1 ou 3, caractérisé en ce que la borne de grille du transistor (17) de commande MOS est reliée à la sortie de l'amplificateur (12) de régulation et sa section drain-source est montée en parallèle avec la section drain-source de l'un des transistors (4) d'entrée MOS de l'étage (1, 2, 3, 4, 7, 8) d'extrémité pour de petites puissances de sortie.
